(19) Europäisches Patentamt
European Patent Office
Office européen des brevets

(11) Publication number: **0 044 586**
**B1**

(12) **EUROPEAN PATENT SPECIFICATION**

(45) Date of publication of patent specification: **01.08.84**

(51) Int. Cl.³: **H 01 F 10/24,** G 11 C 19/08

(21) Application number: **81200763.1**

(22) Date of filing: **03.07.81**

(54) **Device for propagating magnetic domains.**

(30) Priority: **22.07.80 NL 8004201**

(43) Date of publication of application:
**27.01.82 Bulletin 82/4**

(45) Publication of the grant of the patent:
**01.08.84 Bulletin 84/31**

(84) Designated Contracting States:
**DE FR GB IT NL SE**

(56) References cited:
**DE - A - 2 232 902**
**DE - A - 2 431 419**
**US - A - 4 138 530**

**IEEE TRANSACTIONS ON MAGNETICS, vol. MAG 10, no. 3, September 1974, G. DIONNE "Stress effects on remanence ratios from changes in spike domain volume", pages 947-949**
**JOURNAL OF APPLIED PHYSICS, vol. 51, no. 5, May 1980, New York, US D. BREED et al. "Fast wall motion in garnet films with orthorhombic anisotropy", pages 2780-2783**

(73) Proprietor: **N.V. Philips' Gloeilampenfabrieken**
**Groenewoudseweg 1**
**NL-5621 BA Eindhoven (NL)**

(72) Inventor: **Breed, Dirk Jacobus**
**c/o INT. OCTROOIBUREAU B.V. Prof. Holstlaan 6**
**NL-5656 AA Eindhoven (NL)**
Inventor: **van Bakel, Bernardus Albertus**
**c/o INT. OCTROOIBUREAU B.V. Prof. Holstlaan 6**
**NL-5656 AA Eindhoven (NL)**
Inventor: **Voermans, Antonius Bernard**
**c/o INT. OCTROOIBUREAU B.V. Prof. Holstlaan 6**
**NL-5656 AA Eindhoven (NL)**
Inventor: **Robertson, John MacKay**
**c/o INT. OCTROOIBUREAU B.V. Prof. Holstlaan 6**
**NL-5656 AA Eindhoven (NL)**

(74) Representative: **Koppen, Jan et al,**
**INTERNATIONAAL OCTROOIBUREAU B.V. Prof. Holstlaan 6**
**NL-5656 AA Eindhoven (NL)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**EP 0 044 586 B1**

## Description

The invention relates to a device for propagating magnetic domains, including a monocrystalline non-magnetic substrate bearing a layer of an iron garnet capable of supporting local enclosed magnetic domains, said layer having a mechanical stress-induced uniaxial magnetic anisotropy component and having been caused to grow in compression on the non-magnetic substrate, said iron-garnet being of the class of iron garnet materials with positive magnetostriction constants.

In magnetic "bubble" domain devices, it holds that the smaller the bubble diameter, the larger the information storage density which can be achieved. Iron garnet bubble domain materials are preferred in bubble domain technology because small diameter bubble domains are stable in these materials. For a bubble domain material which must be useful for the manufacture of bubble domain devices, it is important that the bubbles formed in the material should have a high wall mobility so that comparatively small driving fields can cause rapid bubble movements. This property enables the use of high frequencies at low energy dissipation.

It is also important that the magnetic bubble domain materials should have a high uniaxial anisotropy. This proves to be necessary to avoid spontaneous nucleation of bubbles. This of great importance for reliable information storage and processing within the bubble domain material.

The overall uniaxial anisotropy ($K_u$) may have contributions of stress-induced ($K_u^s$) and growth-induced ($K_u^g$) components. This means

$$K_u \approx K_u^s + K_u^g \qquad (1)$$

In a bubble domain material known from German Offenlegungsschrift 2,232,902, $K_u$ is mainly determined by the stress-induced component.

This known bubble domain material is obtained by depositing an iron garnet film having a single crystal with the correct crystallographic orientation and with a positive magnetostriction constant on a substrate, in which the lattice constant of the film is larger than the lattice constant of the substrate. When plates having a single crystal with positive magnetostriction constant are under a mechanical stress, the magnetostriction contribution tends to make an easy axis of magnetization perpendicular to the plane of the plate if the plate is in compression. The bubble domain material realized in practice on the basis of the above concept was a (111) oriented film of $Tb_3Fe_5O_{12}$ which had been deposited on a $Sm_3Ga_5O_{12}$ substrate, which means that the value of the required positive magnetostriction constant is determined by the choice of the rare earth ion in the bubble domain material and that the mechanical stress is determined by the choice of the substrate. This route does not lead to a bubble domain material which is suitable for propagating therein bubble domains having a diameter smaller than 1 $\mu$m while using comparatively low driving fields, for which purpose a high $K_u$ and a high wall mobility are required and which can moreover be deposited on a $Gd_3Ga_5O_{12}$ substrate. As a matter of fact, the realization of a high $K_u$ by means of the incorporation of rare earth ions having a high positive magneto-striction constant inevitably leads to the use of Sm and Eu ions which provide a considerable contribution to the damping, while the realization of a high $K_u$ by increasing the compression of the film is on the one hand possible only to a restricted extent, because when the compression force becomes too large, the compression removes itself and the film comes under a tensile stress, and on the other hand leads to the use of substrate materials deviating from $Gd_3Ga_5O_{12}$ (lattice parameter 12.376).

It is the object of the invention to provide a device of the kind mentioned in the opening paragraph having a bubble domain layer which is deposited on $RE_3Ga_5O_{12}$ and which is suitable for the propagation of submicron bubble domains with comparatively small driving fields (RE is selected from the group of rare earth ions, and preferably is Gd), because $Gd_3Ga_5O_{12}$ is the most common substrate material.

This object is achieved by using as a bubble domain material an iron garnet which in a part of the iron lattice sites comprises manganese and in which the dodecahedral lattice site occupants contribute little to the damping, which material has been deposited on a (100) face of a rare earth gallium garnet substrate.

With this type of material in which the magnetostriction constant is determined by the Mn-ion, and for the occupation of the dodecahedron sites ions can thus be selected on the basis of their low damping and not on the basis of their high magneto-striction constant, it has been found that magnetic anisotropy constants $K_u$ of $1 \times 10^5$ to $2 \times 10^5$ erg/cm$^3$ can be achieved so that this material is suitable for use in bubble domain devices having sub-micron bubble domains of a diameter as small as, for example, 0.4 $\mu$m. The crystallographic orientation of the bubble domain layer has been chosen so as to have the maximum advantage of the positive magneto-striction constant of Mn. Gadolinium and yttrium may be used as low damping (rare earth) ions. By choosing the Gd/Y ratio, the "misfit" and hence the mechanical stress can be adjusted.

A preferred material for maximizing the stress-induced anisotropy is

$$\{Bi, Y\}_3(Fe, Mn, Ga)_5O_{12}.$$

By a suitable choice of the Bi/Y ratio, the misfit can be adjusted without the satura-

tion magnetization $4\pi M_s$ decreasing too much, as may be the case when Gd/Y is used and then can only be reduced by omitting gallium which upon substitution in the iron places reduces the magnetization. Where elements different from gallium can be substituted for iron and where for certain purposes small quantities of rare earth ions can be incorporated in the dodecahedral lattice sites, a more general formula for this material is

$\{Bi, Y, RE\}_3(Fe, Mn, Q)_5O_{12}$,

wherein Q is a non-magnetic ion which preferably substitutes in the tetrahedral lattice sites.

Depending on the anisotropy for certain applications, a combination of magnetostriction constant (for which Mn is incorporated) and difference in lattice parameter of film and substrate is required. It has proved possible, for example, to grow the present films in compression on a gadolinium-gallium substrate with a "mismatch"

$$\frac{a_o - a_1}{a_o}$$

as large as $-1 \times 10^{-2}$ which satisfies all requirements (no cracks, tears, etc.). However, for most applications the "mismatch" will lie between $-1 \times 10^{-3}$ and $-6 \times 10^{-3}$.

It is noted that from the Journal of Applied Physics, Volume 51, No. 5, May 1980, p. 2780—2783 there is known a device for propagating magnetic domain walls having a garnet film, which comprises manganese in part of the iron lattice sites and gadolinium and yttrium, ions which contribute little to damping, in the dodecahedral sites. However, said garnet film is grown under compression on a (110) orientated substrate, whereby an orthorhombic anisotropy is produced in the film. It is disclosed that the maximum value of the uniaxial anisotropy component obtainable in this type of film is $6.5 \times 10^4$ erg/cm³, which means that the diameter of the bubbles produced in this type of film can not be smaller than 1 $\mu$m.

The invention will be described in greater detail with reference to the following examples and the drawing.

The Figure diagrammatically shows a bubble domain device.

Films of the nominal composition

$\{Gd, Y\}_3(Fe, Mn, Ga)_5O_{12}$

were grown on a first series of GGG substrates by liquid phase epitaxy methods from a melt while using a $PbO/B_2O_3$ flux. The Ga content was varied to adjust the saturation magnetization, the ratio $Gd_2O_3/Y_2O_3$ in the melt was varied to vary the lattice constnat of the deposited layer, and the Mn content was varied to adapt the magneto-elastic constant. While using a $PbO/B_2O_3$ melt, films of the nominal composition

$\{Bi, Y\}_3(Fe, Mn, Ga)_5O_{12}$

were also deposited on a second series of GGG substrates.

The layers were grown on substrates which were dipped horizontally in the melt and had a diameter of 2.5 cm and a (100) oriented deposition face at temperatures between 750 and 950°C for periods which varied from 0.25—2 minutes, the substrates being rotated at 100 rpm, while after every 5 revolutions the direction of rotation was reversed. The film thicknesses varied from 0.5 to 4.5 $\mu$m.

Example 1

For the growth of a layer of the nominal composition

$\{Gd, Y\}_3(Fe, Mn, Ga)_5O_{12}$,

the following oxides were weighed out in the following quantities:

| | |
|---|---|
| PbO | 87 g |
| $B_2O_3$ | 1.81 g |
| $Y_2O_3$ | 0.27 g |
| $Gd_2O_3$ | 0.37 g |
| $Ga_2O_3$ | 0.46 g |
| $Fe_2O_3$ | 8.18 g |
| $Mn_2O_3$ | 1.86 g |

The mixture was melted and heated at a temperature of 876°C. A $Gd_5Ga_5O_{12}$ substrate having a (100) oriented deposition face was dipped in the melt for 2 minutes, resulting in the deposition of a layer of 4.4 $\mu$m thickness. Estimated composition of the layer: $Y_{1.1}$, $Gd_{1.9}$, $Fe_{3.8}$, $Mn_{0.7}$, $Ga_{0.5}$, $O_{12}$.

Example 2

For the growth of a layer of the nominal composition

$\{Y, Gd\}_3(Fe, Mn)_5O_{12}$,

the following oxides were weighed out in the following quantities:

| | |
|---|---|
| $B_2O_3$ | 1.81 g |
| PbO | 87 g |
| $Y_2O_3$ | 0.27 g |
| $Gd_2O_3$ | 0.37 g |
| $Fe_2O_3$ | 8.18 g |
| $Mn_2O_3$ | 1.86 g |

The mixture was melted and heated at a temperature of 876°C. A $Gd_3Ga_5O_{12}$ substrate having a (100) oriented deposition face was dipped in the melt for 15 seconds resulting in the deposition of a 0.55 $\mu$m thick layer. Estimated composition of the layer: $Y_{1.1}$, $Gd_{1.9}$, $Fe_{3.8}$, $Mn_{1.2}$, $O_{12}$.

Example 3

For the growth of a layer of the nominal

composition

{Y, Gd}$_3$(Me, Mn, Ga)$_5$O$_{12}$,

the following oxides were weighed out in the following quantities:

| | |
|---|---|
| PbO | 84 g |
| $B_2O_3$ | 1.81 g |
| $Y_2O_3$ | 0.36 g |
| $Gd_2O_3$ | 0.23 g |
| $Ga_2O_3$ | 0,46 g |
| $Fe_2O_3$ | 8.18 g |
| $Mn_2O_3$ | 1.86 g |

The mixture was melted and heated at a temperature of 898°C. A $Gd_3Ga_5O_{12}$ substrate having a (100) oriented deposition face was dipped in the melt for 2 minutes of 3.88 $\mu$m. Estimated composition of the layer: $Y_{2.1}$, $Gd_{0.9}$, $Fe_{3.8}$, $Mn_{0.7}$, $Ga_{0.5}$, $O_{12}$.

Example 4

For the growth of a layer of the nominal composition

{Bi, Y}$_3$(Fe, Mn, Ga)$_5$O$_{12}$,

the following material were weighed out in the following quantities:

| | |
|---|---|
| $Bi_2O_3$ | 133.47 g |
| PbO | 319.71 g |
| $MnCO_3$ | 12.00 g |
| $Y_2O_3$ | 2.0 g |
| $Fe_2O$ | 29.88 g |
| $Ga_2O_3$ | 0.1 g |

The mixture was melted and heated at a temperature of 778°C. A $Gd_3Ga_5O_{12}$ substrate having a (100) oriented deposition face was dipped in the melt for 60 seconds resulting in the deposition of a layer having a thickness of 0.76 $\mu$m.

The Table below gives the properties of the magnetic layers grown by the processes described in Examples 1 to 4 above.

TABLE

| EXAMPLE | 1 | 2 | 3 | 4 |
|---|---|---|---|---|
| $(a_0 - a_1)/a_0$ | $-2.5 \times 10^{-3}$ | | $-1.08 \times 10^{-3}$ | $-3.16 \times 10^{-3}$ |
| B($\mu$m) | 3.59 | | 2.04 | |
| $K_u$ (erg/cm$^3$) | $2 \times 10^5$ | | $9.3 \times 10^4$ | $1.8 \times 10^5$ |
| $\Delta H$ (Oe) | | | 25 | 10 |
| $4\pi M_S$ (Gauss) | 467 | 1300 | 665 | 1779 |
| $\mu$(m sec$^{-1}$ Oe$^{-1}$) | 11 | 44* | 23 | 60* |
| Q | 23 | 3.1* | 5.6 | 1.4 |

In the above Table, B is the stable strip domain width, $K_u$ is the uniaxial anisotropy constant, $\Delta H$ is the ferromagnetic resonance line width at 10 $GH_z$, $4\pi M_s$ is the saturation magnetization, $\mu$ is the bubble domain mobility and $Q = H_A/4\pi M$, where $H_A$ is the anisotropy field and $4\pi M$ is the demagnetizing field. The asterisks denotes values which have not been measured directly but were calculated on the basis of other, measured values.

The uniaxial anisotropy constants of the resulting films were determined by means of a torsion magnetometer. Values up to 2 × 10$^5$ erg/cm$^3$ were thus realized for both

{Gd, Y}$_3$(Fe, Mn)$_5$O$_{12}$

and (Bi, Y$_3$)$_3$(Fe, Mn, Ga)$_5$O$_{12}$

films on GGG.

Herewith a new type of bubble domain material has been provided with, also as regards saturation magnetization and mobility, properties which make it excellently suitable for use in bubble domain propagation devices with submicron bubble domains. (Materials with 0.4 $\mu$m diameter bubble domains have been realized). Those skilled in the art will be capable of varying the composition of the bubble domain layer while using the above given general composition and without departing from the scope of this invention. The examples are therefore only by way of illustration and are

not limiting.

In an embodiment to the invention a substrate 1 and a bubble domain layer 2 for the active storage and movements of magnetic domains are used, have a common interface 3, each being characterized by a special nature and by an above-described mutual relation. The layer 2 has an upper surface 4 remote from the interface 3, the surface 4 bearing certain conventional elements for the excitation propagation and sensing of magnetic domains. The layer 2 for storing or moving magnetic domains may, generally speaking, be the place of each of the various processes for digital logics as described elaborately in Patent Specifications and other technical literature. Reference may be made, for example, to the Bell System Technical Journal, XLVI, No. 8, 1901—1925 (1967) which comprises an article entitled "Properties and Device Applications of Magnetic Domains in Orthoferrites".

The Figure of the accompanying drawing shows a rather simple configuration which only represents a fragment of a normally larger construction comprising a layer 2 for storage and movement of magnetic domains and various conventional elements for the excitation, propagation and sensing of magnetic domains. The figure may be considered to be a shift register 5 in which according to the invention a layer 2 is used of a magnetic material having a high uniaxial magnetic anisotropy and a high domain mobility. The easy axis of magnetisation of the layer 2 is perpendicular to the surface 4. The general magnetization condition of layer 2 is represented by lines of magnetic flux perpendicular to the surface 4. Magnetic flux lines situted within the domains and directed opposite to their surroundings are shown by plus signs, for example the plus sign 6 within loop 7.

Conductors 12, 13 and 14 governed by a domain propagator 9, can be connected to or be present in the immediate proximity of the surface 4 of the layer 2. The conductors 12, 13 and 14 are coupled respectively to successive triads of conductive loops, for example loops 8, 8*a*, 8*b* of a first such triad, etc. An array of rows and columns of such multiple loop arrangements is often used in storage systems. The magnetic bias field for stabilizing excited domains is provided in a conventional manner, for example, by using a coil or coils (not shown) which surround the substrate-bubble domain layer configuration, or by using permanent magnets.

During operation of the device the magnetic domains are generated by means of a conventional domain generator 20 combined with a loop 7 which is substantially coaxial with a loop 8. A stable cylindrical magnetic domain, for example, the position of the domain indicated by the plus sign 6, can be propagated in incremental steps from the place of the loop 8 to the place of the loop 8*a*, then to that of the loop 8*b*, etc. by successive excitation of the conductors 12, 13 and 14 etc. by the domain propagator 9. When a propagated magnetic domain reaches loop 8*n*, it can be detected by means of domain sensor 21. It will be obvious that other digital logic functions can easily be carried out while using the same known methods as those which are used in the example of the shift register 5.

**Claims**

1. A device for propagating magnetic domains (6), including a monocrystalline non-magnetic substrate (1) bearing a layer (2) of an iron garnet capable of supporting local enclosed magnetic domains, said layer having a mechanical stress-induced uniaxial magnetic anisotropy component and having been caused to grow in compression on the non-magnetic substrate (1), said iron garnet being of the class of iron garnet materials with positive magnetostriction constants, characterized in that the iron garnet consists of a material which comprises in a part of the iron lattice sites manganese and in that the dodecahedral lattice site occupants contribute little to the damping, which material has been deposited on a (100) face of a rare earth gallium garnet substrate.

2. A device as claimed in Claim 1, provided with first means for magnetically biassing said layer to stabilize said domains, second means (7) for exciting such magnetic domains, third means (8*n*, 21) for detecting the presence of such magnetic domains, and fourth means (8, 8*a*, 8*b*, 9) for propagating such magnetic domains.

3. A device as claimed in Claim 1, characterized in that the non-magnetic garnet material has a first characterizing lattice parameter $a_o$ and that the iron garnet has a second characterizing lattice parameter $a_1$, $a_1 > a_o$, in which

$$-1 \times 10^{-2} \frac{a_o - a_1}{a_o} < -1 \times 10^{-3}.$$

4. A device as claimed in Claim 1, characterized in that the magnetic iron garnet consists of a material which comprises in the dodecahedral sites at least one element selected from the group consisting of gadolinium and yttrium.

5. A device as claimed in Claim 1, characterized in that the magnetic iron garnet consists of a material which comprises bismuth and yytrium in the dodecahedral sites of the garnet lattice.

6. A device as claimed in Claim 1, characterized in that the magnetic iron garnet comprises bismuth, yttrium and a rare earth metal in the dodecahedral sites of the garnet lattice.

7. A device as claimed in Claim 6, characterized in that the magnetic iron garnet consists of a material which may be represented by the formula

$\{Bi, Y, RE\}_3(Fe, Mn, Q)_5O_{12}$,

wherein RE is at least one representative of the group comprising the rare earth metals, and Q is at least one element selected from the group consisting of Ge, Si, Al and Ga.

**Revendications**

1. Dispositif pour la propagation de domaines magnétiques (6), comportant un substrat non magnétique monocristallin (1) supportant une couche (2) d'un grenat de fer pouvant supporter des domaines magnétiques enfermés localement, ladite couche présentant un composant d'anisotropie magnétique uniaxiale induit par tension mécanique et étant formée par croissance sous compression sur le substrat non magnétique (1), ledit grenat de fer étant du groupe de matériaux de grenat de fer présentant des constante de magnétostriction positives, caractérisé en ce que le grenat de fer est constitué par un matériau dans lequel une partie de sites du réseau cristallin de fer comporte du manganèse et dans lequel les occupants des sites de réseau dodécaédriques ne contribuent que faiblement à l'évaporation, ce matériau ayant été déposé sur une face (100) d'un substrat de grenat de gallium des terres rares.

2. Dispositif selon la revendication 1, muni de premiers moyens pour la polarisation magnétique de ladite couche pour stabiliser lesdits domaines, de deuxièmes moyens (7) pour l'excitation de tels domaines magnétiques, de troisièmes moyens (8n, 21) pour la détection de la présence de tels domaines magnétiques et de quatriémes domaines (8, 8*a*, 8*b*, 9) pour la propagation de tels domaines magnétiques.

3. Dispositif selon la revendication 1, caractérisé en ce que le matériau de grenat non magnétique présente un premier paramètre de réseau caractéristique $a_o$ et que le grenat de fer présente un second paramètre de réseau caractéristique $a_1$, $a_1 > a_o$, dans lequel

$$-1 \times 10^{-2} \frac{a_o - a_1}{a_o} < -1 \times 10^{-3}.$$

4. Dispositif selon la revendication 1, caractérisé en ce que le grenat de fer magnétique est constitué par un matériau, présentant dans les sites dodécaédriques au moins un élément sélectionné dans le groupe constitué par du gadolinium et de l'yttrium.

5. Dispositif selon la revendication 1, caractérisé en ce que le grenat de fer magnétique est constitué par un matériau contenant le bismuth et de l'yttrium dans les sites dodécaédriques du réseau de grenat.

6. Dispositif selon la revendication 1, caractérisé en ce que le grenat de fer magnétique contient du bismuth de l'yttrium et un métal des terres rares dans les sites dodécaédriques du réseau de grenat.

7. Dispositif selon la revendication 6, caractérisé en ce que le grenat de fer magnétique est constitué par un matériau qui peut être représenté par la formule

$\{Bi, Y, RE\}_3(Fe, Mn, Q)_5O_{12}$,

formule dans laquelle R est au moins un représentant du groupe constitué par les métaux des terres rares et Q est au moins un élément sélectionné dans le groupe constitué par Ge, Si, Al et Ga.

**Patentansprüche**

1. Anordnung für die Fortbewegung magnetischer Domänen (6) mit einem monokristallinen nichtmagnetischen Substrat (1), auf dem eine Eisengranatschicht (2) angebracht ist, die stellenweise eingeschlossene magnetische Domänen tragen kann, die eine mechanische, spannungsinduzierte, uniaxiale, magnetische Anisotropiekomponente enthält und die unter Druckausübung auf dem nichtmagnetischen Substrat (1) gezüchtet wurde, wobei der Eisengranat zur Gruppe von Eisengranatmaterialien mit positiven Magnetostricktionskonstanten gehört, dadurch gekennzeichnet, dass der Eisengranat aus einem Material besteht, bei dem ein Teil der Eisengitterplätze Mangan und die Dodekaeder-Eisengitterplätze Ionen enthalten die wenig zur Dämpfung beitragen, wobei das Material auf einer (100)-Flache eines Seltenerdmetall-Galliumgranatsubstrats abgelagert ist.

2. Anordnung nach Anspruch 1, dadurch gekennzeichnet, dass erstens Mittel zum magnetischen Vorspannen der genannten Schicht zum Stabilisieren der Domänen, zweitens Mittel (7) zum Anregen derartiger magnetischer Domänen, drittens Mittel (8n, 21) zum Detektieren derartiger magnetischer Domänen und viertens Mittel (8, 8a, 8b, 9) zum Fortbewegen derartiger magnetischen Domänen vorgesehen sind.

3. Anordnung nach Anspruch 1, dadurch gekennzeichnet, dass das nichtmagnetische Granatmaterial einen ersten kennzeichnender Gitterparameter $a_o$ und der Eisengranat einen zweiten kennzeichnenden Gitterparameter $a_1$ ($a_1 > a_o$) hat, worin

$$-1 \times 10^{-2} \frac{a_o - a_1}{a_o} < -1 \times 10^{-3} \text{ ist.}$$

4. Anordnung nach Anspruch 1, dadurch gekennzeichnet, dass der magnetische Eisengranat aus einem Material besteht, das auf den Dodekaederplätzen zumindest ein Element enthält, das aus der aus Gadolinium und Yttrium bestehenden Gruppe ausgewählt ist.

5. Anordnung nach Anspruch 1, dadurch gekennzeichnet, dass der magnetische Eisengranat aus einem Material besteht, das auf den Dodekaederplätzen des Granatgitters Wismut

und Yttrium enthält.

6. Anordnung nach Anspruch 1, dadurch gekennzeichnet, dass der magnetische Eisengranat Wismit, Yttrium und ein Seltenerdmetall auf den Dodekaederplätzen des Granatgitters enthält.

7. Anordnung nach Anspruch 6, dadurch gekennzeichnet, dass der magnetische Eisengranat aus einem Material besteht, das durch die Formel

$$\{Bi, Y, RE\}_3(Fe, Mn, Q)_5O_{12},$$

dargestellt wird, worin RE zumindest ein Vertreter der die Seltenerdmetalle enthaltenden Gruppe ist und Q zumindest ein Element ist, das aus der aus Ge, Si, Al und Ga bestehenden Gruppe ausgewählt ist.

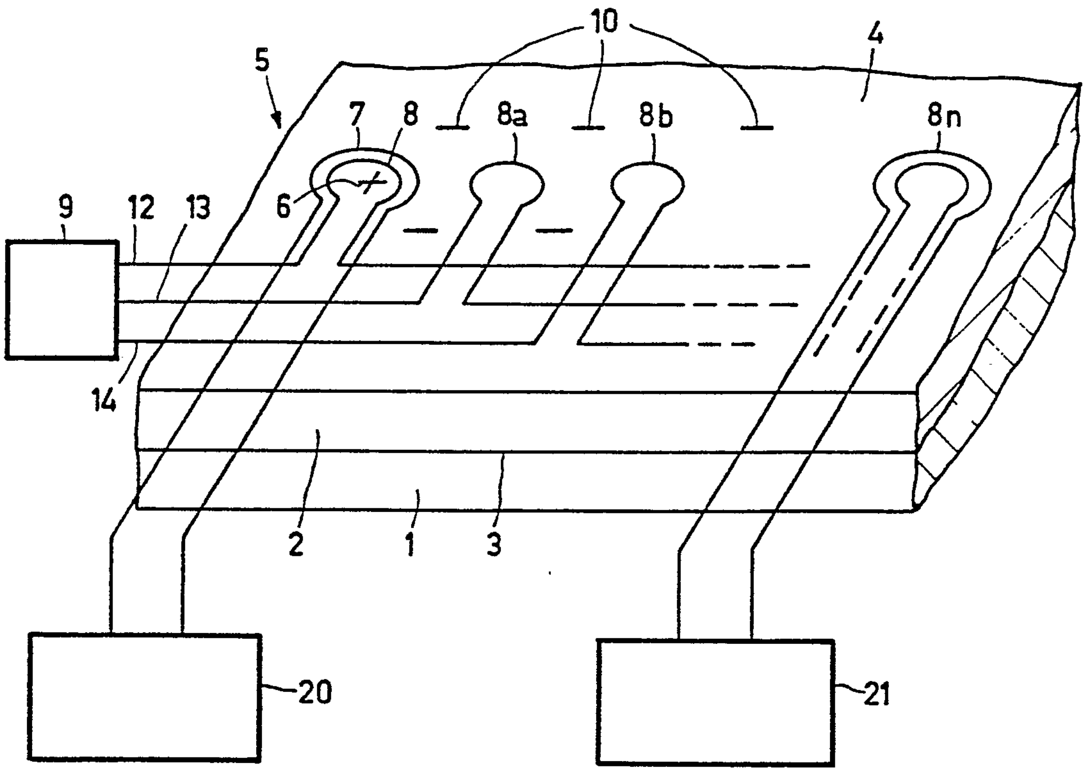
10
4
5
7
8
8a
8b
8n
9
12
13
6
14
2
1
3
20
21